# EUROPEAN PATENT APPLICATION

(11) **EP 4 840 923 A1**
(43) Date of publication of application: **18.11.2026**
(21) Application number: 26178028.2
(22) Date of filing: 11.05.2026
(51) Int. Cl.: C09K 5/14, C08K 3/22, C08K 5/01, C08L 23/22, C08L 91/00, H10W 40/70

(54) **ENHANCING PERFORMANCE OF THERMAL INTERFACE MATERIALS BY USING THERMOPLASTIC THICKENERS**

(30) Priority: 14.05.2025 US 202563805674 P; 15.04.2026 US 202664040389 P
(71) Applicant: Laird Technologies, Inc., Chesterfield, MO 63017 (US)
(72) Inventor: BRUZDA, Karen J., Chesterfield, 63017 (US); RYAN, John, Chesterfield, 63017 (US)
(74) Representative: Lind Edlund Kenamets Intellectual Property AB

(57) **Abstract**

The present disclosure relates to the use of thermoplastic thickeners to enhance performance of materials useful for the management of heat and/or electromagnetic interference (EMI), *e.g*., such that the materials are usable with less oil bleed and/or less occurrence of hardening over time at elevated temperature, *etc.* The materials may comprise thermal management and/or electromagnetic interference (EMI) mitigation materials, such as thermal interface materials (TIMs) (*e.g*., thermal gap filler pad, thermal phase change material, thermal putty, thermal grease, dispensable thermal interface material, *etc.*), EMI absorber materials, thermally-conductive EMI absorber materials, electrically-conductive materials, combinations thereof, *etc.*

## Description

### FIELD

The present disclosure relates to the use of thermoplastic thickeners to enhance performance of materials useful for the management of heat and/or electromagnetic interference (EMI), e.g., such that the materials are usable with less oil bleed and/or less occurrence of hardening over time at elevated temperature, *etc.* The materials may comprise thermal management and/or electromagnetic interference (EMI) mitigation materials, such as thermal interface materials (TIMs) (e.g., thermal gap filler pad, thermal phase change material, thermal putty, thermal grease, dispensable thermal interface material, *etc*.), EMI absorber materials, thermally-conductive EMI absorber materials, electrically-conductive materials, combinations thereof, *etc.*

### BACKGROUND

This section provides background information related to the present disclosure which is not necessarily prior art.

Electrical components, such as semiconductors, integrated circuit packages, transistors, *etc.,* typically have pre-designed temperatures at which the electrical components optimally operate. Ideally, the pre-designed temperatures approximate the temperature of the surrounding air. But the operation of electrical components generates heat. If the heat is not removed, the electrical components may then operate at temperatures significantly higher than their normal or desirable operating temperature. Such excessive temperatures may adversely affect the operating characteristics of the electrical components and the operation of the associated device.

To avoid or at least reduce the adverse operating characteristics from the heat generation, the heat should be removed, for example, by conducting the heat from the operating electrical component to a heat sink. The heat sink may then be cooled by conventional convection and/or radiation techniques. During conduction, the heat may pass from the operating electrical component to the heat sink either by direct surface contact between the electrical component and heat sink and/or by contact of the electrical component and heat sink surfaces through an intermediate medium or thermal interface material (TIM). The thermal interface material may be used to fill the gap between thermal transfer surfaces, in order to increase thermal transfer efficiency as compared to having the gap filled with air, which is a relatively poor thermal conductor.

In addition, a common problem in the operation of electronic devices is the generation of electromagnetic radiation within the electronic circuitry of the equipment. Such radiation may result in electromagnetic interference (EMI) or radio frequency interference (RFI), which can interfere with the operation of other electronic devices within a certain proximity. Without adequate shielding, EMI/RFI interference may cause degradation or complete loss of important signals, thereby rendering the electronic equipment inefficient or inoperable.

The term "EMI" as used herein should be considered to generally include and refer to EMI emissions and RFI emissions, and the term "electromagnetic" should be considered to generally include and refer to electromagnetic and radio frequency from external sources and internal sources. Accordingly, the term shielding (as used herein) broadly includes and refers to mitigating (or limiting) EMI and/or RFI, such as by absorbing, reflecting, blocking, and/or redirecting the energy or some combination thereof so that it no longer interferes, for example, for government compliance and/or for internal functionality of the electronic component system.

### DRAWINGS

The drawings described herein are for illustrative purposes only of selected embodiments and not all possible implementations and are not intended to limit the scope of the present disclosure.
FIG. 1 shows two thermal gap filler pads (broadly, thermal materials) according to an exemplary embodiment of the present disclosure.
FIG. 2 includes a table of example properties for the thermal gap filler pad shown in FIG. 1 according to an exemplary embodiment of the present disclosure.
FIG. 3 is a line graph of example deflection percentage versus pressure in pounds per square inch (PSI) for the thermal gap filler pad shown in FIG. 1 at eight different thicknesses specifically 0.5 millimeters (mm), 0.75 mm, 1 mm, 1.5 mm, 2 mm, 3 mm, 4 mm, and 5 mm.
FIG. 4 is a line graph of example thermal resistance (Rth) in degrees Celsius per square inch per Watt (°C•in² /W) versus pressure (PSI) for the thermal gap filler pad shown in FIG. 1 at six different thicknesses specifically 1 mm, 1.5 mm, 2 mm, 3 mm, 4 mm, and 5 mm.

### DETAILED DESCRIPTION

Example embodiments will now be described more fully with reference to the accompanying drawings.

Conventional thermal interface materials (TIMs) may be based on styrenic block copolymer(s), which act as gelling agents of plasticizer oils. But as recognized herein, it would be advantageous to further improve certain physical properties of these materials, such as thermal stability and bleed level without sacrificing other important properties.

There are also conventional silicone free TIMs that utilize resin chemistries, such as reactive chemistries including polyacrylates, crosslinked reactive polybutadiene, *etc.* But as further recognized herein, TIMs based on these chemistries have one or more drawbacks, which may be overcome and/or addressed by exemplary embodiments of the present disclosure.

After recognizing the above, exemplary embodiments were developed and/or are disclosed herein including the use of thermoplastic thickeners to enhance performance of materials useful for the management of heat and/or electromagnetic interference (EMI), *e.g.,* such that the materials are usable with less oil bleed and/or less occurrence of hardening over time at elevated temperature, *etc.* The materials may comprise thermal management and/or electromagnetic interference (EMI) mitigation materials, such as thermal interface materials (TIMs) (*e.g*., thermal gap filler pad, thermal phase change material, thermal putty, thermal grease, dispensable thermal interface material, *etc*.), EMI absorber materials, thermally-conductive EMI absorber materials, electrically-conductive materials, combinations thereof, *etc.*

In exemplary embodiments, TIMs (broadly, materials) may be based on a chemistry that allows for improvement(s) of some common drawbacks associated with some conventional TIMs, such as the presence of silicone, high levels of oil bleed, occurrence of hardening over time at elevated temperature (thermal reliability). In such exemplary embodiments, the TIMs may provide such improvement(s) while maintaining other advantageous aspects of state of the art TIMs, such as one or more of exceptional thermal performance, low sulfur, silicone free, low modulus, thermal reversibility, *etc.*

In exemplary embodiments, polyisobutene (PIB) (*e.g*., hydrogenated (non-reactive) polyisobutene, *etc*.) is used as a thickener as opposed to styrenic block copolymer(s) as thickening agents. The use of polyisobutene as a thickener has proven to result in a more thermally stable thermal interface material (broadly, material) when the PIB based and block copolymer systems are formulated to have equal secant modulus of elasticity/stiffness. Due to the inherently lower secant modulus of elasticity of PIB, less plasticizer oil is needed to produce an equivalently soft pad, yielding improved oil bleed results in a final product. And the final product is also able to maintain other properties such as maintaining high thermal conductivity, low thermal resistance, and high compliance with comparably low levels of sulfur.

Exemplary embodiments disclosed herein may be configured with or include a chemistry that results in a TIM (broadly, material), which is superior to other conventional TIMs on the market when considering the totality of: thermal performance, thermal stability, bleed, secant modulus of elasticity, and acceptance of the base chemistry. Additional benefits of low volatilization/ condensation and low levels of sulfur may also be achieved in exemplary embodiments disclosed herein.

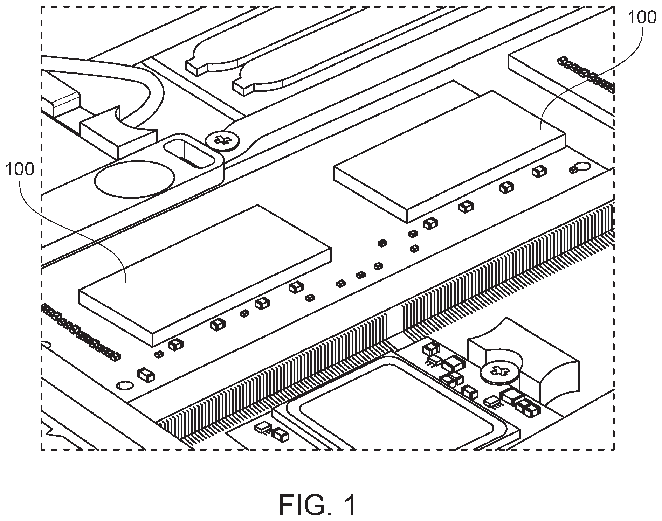

With reference to the figures, FIG. 1 shows two thermal gap filler pads 100 (broadly, thermal materials) according to an exemplary embodiment of the present disclosure. In FIG. 1, the thermal gap filler pads 100 have a rectangular shape but a thermal gap filler pad or other thermal material may have a different shape (*e.g.,* triangular, circular, ovular, polygonal, square, *etc*.) in other exemplary embodiments.

The thermal gap filler pad 100 comprises processing oil and a thermoplastic thickener. The thermoplastic thickener has a durometer less than 10 Shore A 10 seconds at room temperature or a temperature of about 25 degrees Celsius. The thermoplastic thickener comprises polyisobutene (e.g., polyisobutene hydrogenated homopolymer, *etc*.) that does not include block copolymer. The thermoplastic thickener preferably enhances performance of the material (as compared to another material having a similar stiffness/secant module of elasticity and a substantially same filler loading but which includes processing oil and diblock styrenic copolymer and/or triblock styrenic copolymer) by one or more of: less oil bleed; less occurrence of hardening over time at elevated temperature; lower secant modulus of elasticity; and/or achievement of a target secant modulus of elasticity while using less processing oil and a lower processing oil to thickening agent ratio in the material. In exemplary embodiments, the thermoplastic thickener comprises polyisobutene hydrogenated homopolymer.

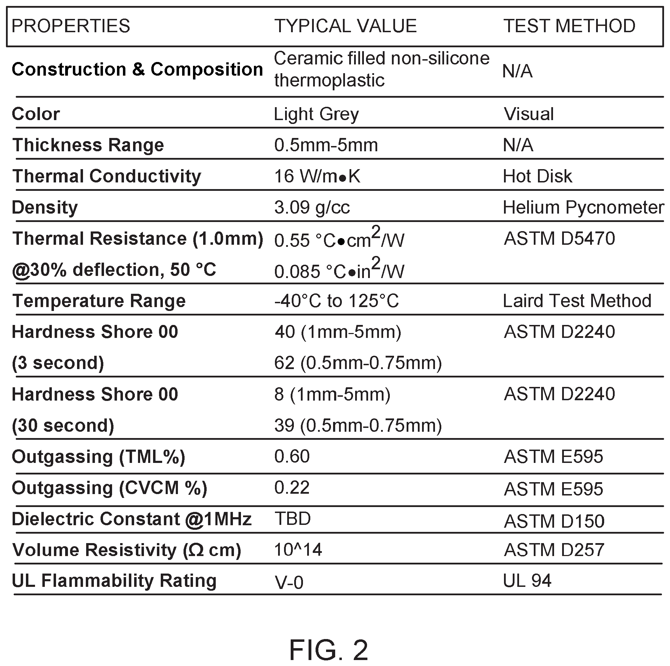

FIG. 2 includes a table of properties for the thermal gap filler pad shown in FIG. 1 according to an exemplary embodiment of the present disclosure. These properties are provided for purpose of example only as a thermal material may be configured differently in other exemplary embodiments such that the thermal material has one or more properties different than the properties shown in FIG. 2.

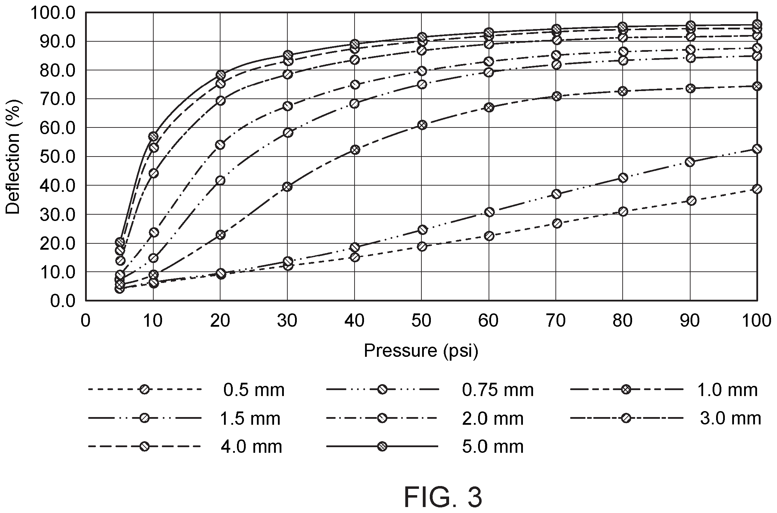

FIG. 3 is a line graph of deflection percentage versus pressure in pounds per square inch (PSI) for the thermal gap filler pad shown in FIG. 1 at eight different thicknesses specifically 0.5 millimeters (mm), 0.75 mm, 1 mm, 1.5 mm, 2 mm, 3 mm, 4 mm, and 5 mm. The line graph shown in FIG. 3 is provided for purpose of example only as a thermal material may be configured differently in other exemplary embodiments such that the thermal material has a thickness and/or deflection versus pressure different than what is shown in FIG. 3.

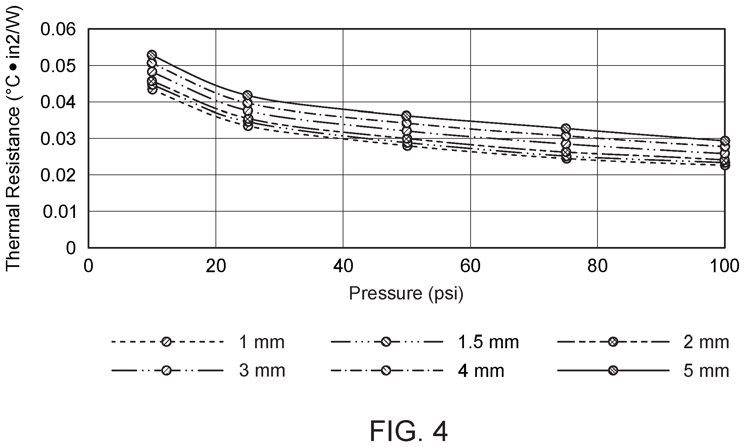

FIG. 4 is a line graph of thermal resistance (Rth) in degrees Celsius per square inch per Watt (°C•in² /W) versus pressure (PSI) for the thermal gap filler pad shown in FIG. 1 at six different thicknesses specifically 1 mm, 1.5 mm, 2 mm, 3 mm, 4 mm, and 5 mm. The line graph shown in FIG. 4 is provided for purpose of example only as a thermal material may be configured differently in other exemplary embodiments such that the thermal material has a thickness and/or thermal resistance versus pressure different than what is shown in FIG. 4.

As shown by FIGS. 2 through 4, the thermal gap filler pad 100 is an innovative, ultrahigh performing thermal non-silicone material having a thermal conductivity of 16 W/m•K in thermal conductivity and excellent deflection properties, which provides minimal pressure on components during deflection. Very little pressure is required to reach the lowest possible thermal resistance. Features and benefits of the thermal gap filler pad 100 include:
- Non-silicone formulation;
- Exceptionally low thermal resistance;
- Low peak and residual pressure;
- Excellent surface wetting for low contact resistance;
- Thermoplastic matrix softens with application heat, further lowering contact resistance;
- Naturally tacky surfaces; and
- Environmentally friendly solution that meets regulatory requirements including RoHS and REACH.

Exemplary materials are disclosed herein that are useful for the management of heat and/or electromagnetic interference (EMI). In exemplary embodiments, the material comprises processing oil and a thermoplastic thickener. The thermoplastic thickener has a durometer less than 10 Shore A 10 seconds at room temperature or a temperature of about 25 degrees Celsius. The thermoplastic thickener may comprises polyisobutene that does not include block copolymer. The thermoplastic thickener preferably enhances performance of the material (as compared to another material having a similar stiffness/secant module of elasticity and a substantially same filler loading but which includes processing oil and diblock styrenic copolymer and/or triblock styrenic copolymer) by one or more of: less oil bleed; less occurrence of hardening over time at elevated temperature; lower secant modulus of elasticity; and/or achievement of a target secant modulus of elasticity while using less processing oil and a lower processing oil to thickening agent ratio in the material.

In exemplary embodiments, the thermoplastic thickener comprises polyisobutene hydrogenated homopolymer. The thermoplastic thickener is soft/compliant, stable, and miscible with the processing oil. The material is free of block copolymer (*e.g.,* styrenic block copolymer, *etc*.) and/or does not include detectable block copolymer (*e.g.,* styrenic block copolymer, *etc*.). The thermoplastic thickener does not include block copolymer such that the thermoplastic thickener enhances performance of the material. In such embodiments, the thermoplastic thickener does not include block copolymer such that the material is usable with less oil bleed and/or less occurrence of hardening over time at elevated temperature as compared to another material having a similar stiffness/secant module of elasticity and a substantially same filler loading but which includes processing oil and diblock styrenic copolymer and/or triblock styrenic copolymer.

In exemplary embodiments, the material includes a non-block copolymer resin system having a lower secant modulus of elasticity than a block copolymer resin system including diblock styrenic copolymer and triblock styrenic copolymer. And the lower secant modulus of elasticity of the non-block copolymer resin system enables the use of less processing oil and a lower processing oil to thickening agent ratio in the material to achieve a target secant modulus of elasticity, whereby the less processing oil and the lower processing oil to thickening agent ratio allows the material including the non-block copolymer resin system to be usable with less oil bleed as compared to a material including the block copolymer resin system and a higher processing oil to thickening agent ratio to achieve the target secant modulus of elasticity.

In exemplary embodiments, the material comprises a resin system that includes the processing oil and the thermoplastic thickener. The resin system may comprise a thermoplastic resin system including the processing oil and the thermoplastic thickener and/or a silicone free resin system including the processing oil and the thermoplastic thickener.

In exemplary embodiments, the material has a thermal conductivity within a range from about 2 Watts per meter per Kelvin (W/mK) to about 30 W/mK as determined by Hot Disk Thermal Constants Analyzer. For example, the material may have a thermal conductivity within a range from about 4 W/mK to about 20 W/mK as determined by Hot Disk Thermal Constants Analyzer. To determine thermal conductivity, a Hot Disk instrument may be used that measures thermal conductivity, thermal diffusivity, and specific heat capacity using the Transient Plane Source Method. By way of background, this technique is covered under the ISO 22007-2:2008; Part 2 Standard. The technique utilizes a plane sensor and a special mathematical model that describes the heat conductivity, combined with electronics that enables the method to be used to measure Thermal Transport Properties. It covers a thermal conductivity range of typically 0.01-500 W/m/K. The Transient Plane Source technique typically employs two samples halves sandwiching the sensor. This method can also be used in a single-sided configuration. The technique is versatile and fast, covering measurements of solids, pastes, thin films and liquids. The technique can test both isotropic and anisotropic material. The flat sensor includes a continuous double spiral of electrically conducting nickel metal, etched out of a thin foil. The nickel spiral is situated between two layers of thin polyimide film Kapton. During the measurement, a constant electrical effect is passed through the conducting spiral, increasing the sensor temperature. The heat generated dissipates into the sample on both sides of the sensor, at a rate depending on the thermal transport properties of the material. By recording temperature versus time response in the sensor, the thermal conductivity, thermal diffusivity, and specific heat capacity of the material can be calculated.

In exemplary embodiments, the processing oil including the thermoplastic thickener has one or more different physical properties than processing oil including styrenic block copolymer including one or more of a different viscosity, a different solubility, and/or a different reactivity. The material may include a ratio of styrenic block copolymer to the processing oil less than 0.1.

In exemplary embodiments, the material is entirely free of silicone and entirely free of styrenic block copolymer. And the material does not include any detectable silicone or detectable styrenic block copolymer. The material may be silicone free such that the material is usable with no occurrence of silicone migration or volatility due to the absence of silicone in the formulation. The material may also be configured to be non-condensing. In such exemplary embodiments, the material may be configured to be non-condensing with less than a predetermined level of condensable volatile components over a predetermined time period at a predetermined temperature. The material may be usable with an oil leakage rate of about 13.5 percent or less (*e.g.,* about 13.4, 13.1, 13.0, or 12.9 percent or less, *etc*.).

In exemplary embodiments, the material comprises a resin matrix and one or more fillers in the resin matrix. In such exemplary embodiments, the one or more fillers may comprise one or more of: thermally-conductive filler(s); electrically-conductive filler(s); electromagnetic wave absorbing filler(s); dielectric filler(s); and filler(s) that has two or more properties of being thermally conductive, electrically conductive, dielectric, and electromagnetic wave absorbing. The one or more fillers (*e.g.,* ranging in size from 0.1 µm to 250 µm (D50), spherical shape, round shape, *etc.*) may comprise one or more of alumina, zinc oxide, boron nitride, silicon nitride, aluminum, aluminum nitride, diamond, aluminum metal powder, iron, metallic oxides, graphite, silicon carbide, ceramic, alumina, zinc oxide, carbonyl iron, silver, aluminum nitride, barium titanate, other thermally-conductive and/or EMI absorbing fillers, combinations thereof, *etc.* In an exemplary embodiment, the TIM includes a thermally-conductive filler consisting only of alumina. In another exemplary embodiment, the TIM includes aluminum nitride filler and alumina filler. In exemplary embodiments, the TIM may also include one or more other additives, such as antioxidant, metal deactivator, and/or dispersant, *etc.* In exemplary embodiments, the material is a thermal interface material, an EMI absorber material, a thermally-conductive absorber material, an electrically-conductive material, or a combination of two or more thereof.

The material may comprise a thermal gap filler pad, a thermal phase change material, a thermal putty, a thermal grease, and/or a dispensable thermal interface material. For example, the material may comprise a thermally-conductive pad having a shape that is rectangular, triangular, circular, ovular, polygonal, *etc.* The thermal interface material may comprise a sheet having a shape that is rectangular, triangular, circular, ovular, polygonal, *etc.* The thermal interface material may comprise a die cut part having a shape that is rectangular, triangular, circular, ovular, polygonal, *etc.* For example, the material may comprise a thermally-conductive electromagnetic interference (EMI) absorber. Or, for example, the material may comprise a thermally reversable, silicone free thermally-conductive gap filler pad.

In exemplary embodiments, a device or system comprises a material as disclosed herein that is used for managing thermal properties of the device or system.

In exemplary embodiments, the material includes thermally-conductive filler and EMI absorbing filler such that the material comprises a multifunctional EMI absorber having a first functionality of EMI mitigation and a second functionality of thermal management, or vice versa. By way of example, the fillers may comprise one or more of functional nanoparticles, electrically-conductive fillers, thermally-conductive fillers, EMI or microwave absorbing fillers, magnetic fillers, coated fillers, combinations thereof, *etc.* The fillers may be added and mixed into a bulk material including the matrix material to thereby provide a mixture of the filler and base or matrix material. Example fillers include carbon black, boron nitride, nickel cobalt, carbonyl iron, iron silicide, iron particles, iron-chrome compounds, silver, an alloy containing 85% iron, 9.5% silicon and 5.5% aluminum, an alloy containing about 20% iron and 80% nickel, ferrites, magnetic alloys, magnetic powders, magnetic flakes, magnetic particles, nickel-based alloys and powders, chrome alloys, oxide, copper, zinc oxide, alumina, graphite, ceramics, silicon carbide, manganese zinc, fiberglass, carbon nanotubes (*e.g*., single-walled carbon nanotubes, multi-walled carbon nanotubes, and/or carbon nanostructures, *etc*.), combinations thereof, *etc.* The fillers may comprise one or more of granules, spheroids, microspheres, ellipsoids, irregular spheroids, strands, flakes, powder, nanotubes, and/or a combination of any or all of these shapes. In addition, exemplary embodiments may also include different grades (*e.g*., different sizes, different purities, different shapes, *etc*.) of the same (or different) fillers.

Also disclosed are exemplary methods of enhancing performance of materials useful for management of heat and/or electromagnetic interference (EMI). The method includes using a thermoplastic thickener with processing oil. The thermoplastic thickener may have a durometer less than 10 Shore A 10 seconds at room temperature or a temperature of about 25 degrees Celsius. The thermoplastic thickener may comprise polyisobutene that does not include block copolymer. The thermoplastic thickener preferably enhances performance of the material (as compared to another material having a similar stiffness/secant module of elasticity and a substantially same filler loading but which includes processing oil and diblock styrenic copolymer and/or triblock styrenic copolymer) by one or more of: less oil bleed; less occurrence of hardening over time at elevated temperature; lower secant modulus of elasticity; and/or achievement of a target secant modulus of elasticity while using less processing oil and a lower processing oil to thickening agent ratio in the material.

In exemplary methods, the thermoplastic thickener comprises polyisobutene hydrogenated homopolymer. The thermoplastic thickener is soft/compliant, stable, and miscible with the processing oil. The material is free of block copolymer (e.g., styrenic block copolymer, etc.) and/or does not include detectable block copolymer (e.g., styrenic block copolymer, etc.). The thermoplastic thickener does not include block copolymer such that the thermoplastic thickener enhances performance of the material. In such exemplary methods, the material is usable with less oil bleed and/or less occurrence of hardening over time at elevated temperature as compared to another material having a similar stiffness/secant module of elasticity and a substantially same filler loading but which includes processing oil and diblock styrenic copolymer and/or triblock styrenic copolymer.

In exemplary methods, the material includes a non-block copolymer resin system having a lower secant modulus of elasticity than a block copolymer resin system including diblock styrenic copolymer and triblock styrenic copolymer. And the lower secant modulus of elasticity of the non-block copolymer resin system enables the use of less processing oil and a lower processing oil to thickening agent ratio in the material to achieve a target secant modulus of elasticity, whereby the less processing oil and the lower processing oil to thickening agent ratio allows the material including the non-block copolymer resin system to be usable with less oil bleed as compared to a material including the block copolymer resin system and a higher processing oil to thickening agent ratio to achieve the target secant modulus of elasticity.

In exemplary methods, a thermoplastic thickener that does not include block copolymer is used to enhance performance of the material (as compared to another material having a similar stiffness/secant module of elasticity and a substantially same filler loading but which includes processing oil and diblock styrenic copolymer and/or triblock styrenic copolymer) by one or more of: less oil bleed; less occurrence of hardening over time at elevated temperature; lower secant modulus of elasticity; and/or achievement of a target secant modulus of elasticity while using less processing oil and a lower processing oil to thickening agent ratio in the material.

In exemplary methods, the material comprises a resin system that includes the processing oil and the thermoplastic polymer. The resin system may comprise a thermoplastic resin system including the processing oil and the thermoplastic polymer and/or a silicone free resin system including the processing oil and the thermoplastic polymer.

In exemplary methods, the method includes adding one or more fillers to the material. The one or more fillers may comprise one or more of: thermally-conductive filler(s); electrically-conductive filler(s); electromagnetic wave absorbing filler(s); dielectric filler(s); and filler(s) that has two or more properties of being thermally conductive, electrically conductive, dielectric, and electromagnetic wave absorbing. The one or more fillers may comprise one or more of alumina, zinc oxide, boron nitride, silicon nitride, aluminum, aluminum nitride, diamond, aluminum metal powder, iron, metallic oxides, graphite, silicon carbide, and ceramic.

In exemplary methods, the material is a thermal interface material, an EMI absorber material, a thermally-conductive absorber material, an electrically-conductive material, or a combination of two or more thereof. For example, the material may comprise a thermal gap filler pad, a thermal phase change material, a thermal putty, a thermal grease, and/or a dispensable thermal interface material.

Or, for example, the material may comprise a thermally-conductive electromagnetic interference (EMI) absorber. As yet another example, the material may comprise a thermally reversable, silicone free thermally-conductive gap filler pad.

The material may be used within a device or system for managing thermal properties of the device or system. In an exemplary embodiment, an electronic device includes a heat source and a material as disclosed herein that is usable as a thermal interface material (*e.g.,* thermally-conductive pad, a thermally-conductive gap filler, a phase change thermal interface material, a dispensable material, a bulk putty, a thermal grease, a sheet of thermal interface material, a thermal transport layer in an optical module, *etc*.). The material is positioned relative to the heat source for establishing at least a portion of a thermally-conductive heat path from the heat source through the material. The material may also be configured to be EMI absorbing and/or electrically conductive, such that the material is also operable for mitigating and/or managing EMI within the electronic device.

In another exemplary embodiment, an electronic device includes a heat source, a heat removal/dissipation structure, and a material as disclosed herein that is usable as a thermal interface material (*e.g.,* thermally-conductive pad, a thermally-conductive gap filler, a phase change thermal interface material, a dispensable material, a bulk putty, a thermal grease, a sheet of thermal interface material, a thermal transport layer in an optical module, *etc*.). The material is positioned relative to the heat source and the heat removal/dissipation structure for establishing at least a portion of a thermally-conductive heat path between the heat source and the heat removal/dissipation structure. The material may also be configured to be EMI absorbing and/or electrically conductive, such that the material is also operable for mitigating and/or managing EMI within the electronic device.

In a further exemplary embodiment, an electronic device includes a heat source, a board level shield, and a material disclosed herein that is usable as a thermal interface material (*e.g.,* thermally-conductive pad, a thermally-conductive gap filler, a phase change thermal interface material, a dispensable material, a bulk putty, a thermal grease, a sheet of thermal interface material, a thermal transport layer in an optical module, *etc*.). The material is positioned relative to the heat source and the board level shield for establishing at least a portion of a thermally-conductive heat path between the heat source and the board level shield. The material may also be configured to be EMI absorbing and/or electrically conductive, such that the material is also operable for mitigating and/or managing EMI within the electronic device.

In an additional exemplary embodiment, an electronic device includes a heat source, a board level shield, a heat removal/dissipation structure, and first and second materials that are usable as thermal interface materials (*e.g.,* thermally-conductive pad, a thermally-conductive gap filler, a phase change thermal interface material, a dispensable material, a bulk putty, a thermal grease, a sheet of thermal interface material, a thermal transport layer in an optical module, *etc*.). The first material is positioned relative to the heat source and the board level shield for establishing at least a portion of a first thermally-conductive heat path between the heat source and the board level shield. The second material is positioned relative to the board level shield and the heat removal/dissipation structure for establishing at least a portion of a second thermally-conductive heat path between the board level shield and the heat removal/dissipation structure. The first and/or second materials may also be configured to be EMI absorbing and/or electrically conductive, such that the first and/or second materials are also operable for mitigating and/or managing EMI within the electronic device.

In yet another exemplary embodiment, an electronic device includes an integrated circuit, a board level shield, a heat sink, and first and second materials that are usable as thermal interface materials (e.g., thermally-conductive pad, a thermally-conductive gap filler, a phase change thermal interface material, a dispensable material, a bulk putty, a thermal grease, a sheet of thermal interface material, a thermal transport layer in an optical module, *etc*.). The first material is positioned relative to the integrated circuit and the board level shield for establishing at least a portion of a first thermally-conductive heat path between the integrated circuit and the board level shield. The second material is positioned relative to the board level shield and the heat sink for establishing at least a portion of a second thermally-conductive heat path between the board level shield and the heat sink. The first and/or second materials may also be configured to be EMI absorbing and/or electrically conductive, such that the first and/or second materials are also operable for mitigating and/or managing EMI within the electronic device.

Exemplary embodiments disclosed herein may be used in a wide range of industries (*e.g.,* automotive, consumer, industrial, datacom/telecom, aerospace/defense, *etc*.) and wide range of applications (*e.g*., automotive electronics, automotive advanced driver-assistance systems (ADAS), automotive powertrain/electronic control units (ECUs), automotive infotainment, routers, hard disk drives, solid state drives, wireless infrastructure, drones/satellites, gaming systems, smart home devices, notebooks/tablets/portable devices, *etc*.). In addition, example embodiments disclosed herein may be used for a wide range of heat sources, electronic devices, and/or heat removal/dissipation structures or components (*e.g*., a heat spreader, a heat sink, a heat pipe, a vapor chamber, a device exterior case, housing, or chassis, *etc.*). For example, a heat source may comprise one or more heat generating components or devices, such as a high-power integrated circuit (IC), optical transceiver, 5G infrastructure devices (*e.g.,* base stations, small cells, smart poles, *etc*.), solid-state drive (SSD), memory in video cards, set top boxes, televisions, gaming systems, automotive electronics used for autonomous driving (ADAS) (*e.g.,* radars, multi domain controllers, cameras, *etc*.), a CPU, die within underfill, semiconductor device, flip chip device, graphics processing unit (GPU), digital signal processor (DSP), multiprocessor system, integrated circuit (IC), multi-core processor, *etc.*). Generally, a heat source may comprise any component or device that has a higher temperature than a thermal management and/or EMI mitigation material or otherwise provides or transfers heat to the thermal management and/or EMI mitigation material regardless of whether the heat is generated by the heat source or merely transferred through or via the heat source. Accordingly, aspects of the present disclosure should not be limited to use with any single type of heat source, electronic device, heat removal/dissipation structure, *etc.*

In exemplary embodiments, a thermal interface material comprises a thermoplastic resin system including a polyisobutene-based thermoplastic thickener and a processing oil that is miscible with the polyisobutene-based thermoplastic thickener, A thermally conductive ceramic filler is dispersed within the thermoplastic resin system. The thermal interface material is free of silicone, free of styrenic block copolymers, and free of curing agents such that the material remains non-crosslinked and non-curing during use. The thermal interface material is thermoplastically reversible at temperatures encountered during normal device operation and is configured to soften under application heat without undergoing chemical curing or phase-change melting, thereby improving conformability to opposing heat transfer surface and reducing interfacial contact resistance after assembly. When tested in accordance with ASTM D5470, the thermal interface material achieves a thermal resistance of no greater than 0.60 °C·cm²/W at 30 percent compressive deflection under an applied pressure of 30 psi or less.

The thermal interface materials disclosed herein are distinct from known thermal interface materials in both composition and functional behavior. Unlike conventional thermal interface materials that rely on silicone elastomers, styrenic block copolymer networks, or cure-in-place resin systems, exemplary thermal interface materials disclosed herein employ a polyisobutene-based thermoplastic thickener that is non-crosslinked and remains thermoplastically reversible throughout its service life. This architecture enables the thermal interface materials to soften under application heat encountered during device operation without chemical curing or phase-change melting, a behavior that is different than prior silicone-based, elastomeric, or phase-change thermal interface materials.

In contrast to conventional cured liquid gap fillers and elastomeric pads that irreversibly set or harden after installation, the exemplary thermoplastic resin systems disclosed herein maintain reversibility and elastic compliance while still achieving low thermal resistance at low assembly pressures. Prior approaches typically achieve low thermal resistance either through curing reactions, high assembly pressures, or phase-change transitions at defined melting points. In exemplary embodiments disclosed herein, the thermal interface materials achieve low thermal resistance through a thermoplastic softening mechanism enabled by the miscibility of the polyisobutene-based thickener with the processing oil, allowing improved surface wetting and conformability during operation without sacrificing long-term mechanical stability.

Additionally, the disclosed thermal interface materials are distinguishable from known silicone-free thermal interface materials that rely on curable resin chemistries or pressure-sensitive adhesive systems. In exemplary embodiments disclosed herein, the absence of curing agents, catalysts, and styrenic block copolymers prevents the formation of permanent polymer networks and avoids the creep, hardening, or volatility issues commonly associated with such conventional systems. The combination of a non-curing polyisobutene-based thermoplastic thickener with a ceramic thermally conductive filler provides a unique balance of thermal conductivity, low applied stress, and long-term reliability that is not achieved by known material systems.

The ability of the thermal interface materials disclosed herein to achieve a thermal resistance of no greater than 0.60 °C·cm²/W at 30 percent compressive deflection under an applied pressure of 30 psi or less is further distinguishable from prior materials that depend on higher mounting pressures or curing processes to reach comparable thermal performance. This pressure-defined performance characteristic reflects a material behavior arising from the specific thermoplastic architecture disclosed herein, rather than from generic low-modulus formulations.

Accordingly, the thermal interface materials disclosed herein can simultaneously achieve low thermal resistance and low applied stress without relying on silicone elastomers, styrenic block copolymer networks, or curing reactions. By employing a polyisobutene-based thermoplastic thickener that is miscible with a processing oil, the thermoplastic resin systems disclosed herein remain non-crosslinked and thermoplastically reversible, even after assembly and during operation of an electronic device. As a result, the thermal interface material softens in response to application heat generated during device operation, which improves surface wetting and conformability to opposing heat transfer surfaces, leading to reduced interfacial thermal resistance.

Because the thermal interface materials disclosed herein do not undergo chemical curing or phase-change melting, deterioration in compliance due to hardening, curing shrinkage, or irreversible structural change can be suppressed. This makes it possible to maintain stable thermal performance over repeated thermal cycles and long-term use. Furthermore, the disclosed thermal interface materials may be free of silicone and styrenic block copolymers, thereby effectively avoiding problems associated with block copolymer domains such as silicone migration, volatility, contamination, or mechanical instability.

Moreover, the thermal interface materials disclosed herein may achieve a thermal resistance of 0.60 °C·cm²/W or less at a compressive deflection of 30 percent under an applied pressure of 30 psi or less. Accordingly, high thermal performance can be realized under low assembly pressure, which is advantageous for electronic components that are sensitive to mechanical stress. In contrast to conventional cured gap fillers or elastomeric pads that require higher mounting pressures or curing processes to obtain comparable thermal performance, the exemplary thermal interface materials disclosed herein enable efficient heat transfer while reducing stress applied to electronic components, thereby improving reliability of the electronic device.

Various aspects of the invention according to the present disclosure include, but are not limited to, the aspects listed in the following numbered clauses.

Clause 1: A material useful for the management of heat and/or electromagnetic interference (EMI), the material comprising processing oil and a thermoplastic thickener having a durometer less than 10 Shore A 10 seconds at room temperature or a temperature of about 25 degrees Celsius.

Clause 2: A material useful for the management of heat and/or electromagnetic interference (EMI), the material comprising processing oil and a thermoplastic thickener that does not include block copolymer such that the thermoplastic thickener enhances performance of the material (as compared to another material having a similar stiffness/secant module of elasticity and a substantially same filler loading but which includes processing oil and diblock styrenic copolymer and/or triblock styrenic copolymer) by one or more of: less oil bleed; less occurrence of hardening over time at elevated temperature; lower secant modulus of elasticity; and/or achievement of a target secant modulus of elasticity while using less processing oil and a lower processing oil to thickening agent ratio in the material.

Clause 3: A material useful for the management of heat and/or electromagnetic interference (EMI), the material comprising processing oil and a thermoplastic thickener, wherein the thermoplastic thickener comprises polyisobutene.

Clause 4: The material of clause 1 or 2, wherein the thermoplastic thickener comprises polyisobutene.

Clause 5: The material of clause 2, 3, or 4, wherein the thermoplastic thickener has a durometer less than 10 Shore A 10 seconds at room temperature or a temperature of about 25 degrees Celsius.

Clause 6: The material of any preceding clause, wherein the thermoplastic thickener comprises polyisobutene hydrogenated homopolymer.

Clause 7: The material of any preceding clause, wherein the thermoplastic thickener is soft/compliant, stable, and miscible with the processing oil.

Clause 8: The material of any preceding clause, wherein the material is free of styrenic block copolymer and/or does not include detectable styrenic block copolymer.

Clause 9: The material of any preceding clause, wherein the material is free of block copolymer and/or does not include detectable block copolymer.

Clause 10: The material of any preceding clause, wherein the thermoplastic thickener does not include block copolymer such that the thermoplastic thickener enhances performance of the material.

Clause 11: The material of any preceding clause, wherein the thermoplastic thickener does not include block copolymer such that the material is usable with less oil bleed and/or less occurrence of hardening over time at elevated temperature as compared to another material having a similar stiffness/secant module of elasticity and a substantially same filler loading but which includes processing oil and diblock styrenic copolymer and/or triblock styrenic copolymer.

Clause 12: The material of any preceding clause, wherein: the material includes a non-block copolymer resin system having a lower secant modulus of elasticity than a block copolymer resin system including diblock styrenic copolymer and triblock styrenic copolymer; and the lower secant modulus of elasticity of the non-block copolymer resin system enables the use of less processing oil and a lower processing oil to thickening agent ratio in the material to achieve a target secant modulus of elasticity, whereby the less processing oil and the lower processing oil to thickening agent ratio allows the material including the non-block copolymer resin system to be usable with less oil bleed as compared to a material including the block copolymer resin system and a higher processing oil to thickening agent ratio to achieve the target secant modulus of elasticity.

Clause 13: The material of any preceding clause, wherein the thermoplastic thickener does not include block copolymer for enhancing performance of the material (as compared to another material having a similar stiffness/secant module of elasticity and a substantially same filler loading but which includes processing oil and diblock styrenic copolymer and/or triblock styrenic copolymer) by one or more of: less oil bleed; less occurrence of hardening over time at elevated temperature; lower secant modulus of elasticity; and/or achievement of a target secant modulus of elasticity while using less processing oil and a lower processing oil to thickening agent ratio in the material.

Clause 14: The material of any preceding clause, wherein the material comprises a resin system that includes the processing oil and the thermoplastic thickener.

Clause 15: The material of clause 14, wherein the resin system comprises: a thermoplastic resin system including the processing oil and the thermoplastic thickener; and/or a silicone free resin system including the processing oil and the thermoplastic thickener.

Clause 16: The material of any preceding clause, wherein the material has a thermal conductivity within a range from about 2 Watts per meter per Kelvin (W/mK) to about 30 W/mK as determined by Hot Disk Thermal Constants Analyzer.

Clause 17: The material of clause 16, wherein the material has a thermal conductivity within a range from about 4 W/mK to about 20 W/mK as determined by Hot Disk Thermal Constants Analyzer.

Clause 18: The material of any preceding clause, wherein the processing oil including the thermoplastic thickener has one or more different physical properties than processing oil including styrenic block copolymer including one or more of a different viscosity, a different solubility, and/or a different reactivity.

Clause 19: The material of any preceding clause, wherein the material includes a ratio of styrenic block copolymer to the processing oil less than 0.1.

Clause 20: The material of any preceding clause, wherein: the material is entirely free of silicone and entirely free of styrenic block copolymer; and/or the material does not include any detectable silicone or detectable styrenic block copolymer.

Clause 21: The material of any preceding clause, wherein the material is configured to be non-condensing.

Clause 22: The material of clause 21, wherein the material is configured to be non-condensing with less than a predetermined level of condensable volatile components over a predetermined time period at a predetermined temperature.

Clause 23: The material of any preceding clause, wherein the material is usable with an oil leakage rate of about 13.5 percent or less.

Clause 24: The material of any preceding clause, wherein the material is silicone free such that the material is usable with no occurrence of silicone migration or volatility due to the absence of silicone in the formulation.

Clause 25: The material of any preceding clause, wherein: the material comprises a resin matrix; and the material further comprises one or more fillers in the resin matrix.

Clause 26: The material of clause 25, wherein the one or more fillers comprise one or more of: thermally-conductive filler(s); electrically-conductive filler(s); electromagnetic wave absorbing filler(s); dielectric filler(s); and filler(s) that has two or more properties of being thermally conductive, electrically conductive, dielectric, and electromagnetic wave absorbing.

Clause 27: The material of clause 25 or 26, wherein the one or more fillers comprise one or more of alumina, zinc oxide, boron nitride, silicon nitride, aluminum, aluminum nitride, diamond, aluminum metal powder, iron, metallic oxides, graphite, silicon carbide, and ceramic.

Clause 28: The material of any preceding clause, wherein the material is a thermal interface material, an EMI absorber material, a thermally-conductive absorber material, an electrically-conductive material, or a combination of two or more thereof.

Clause 29: The material of any preceding clause, wherein the material comprises a thermal gap filler pad, a thermal phase change material, a thermal putty, a thermal grease, and/or a dispensable thermal interface material.

Clause 30: The material of any preceding clause, wherein the material comprises a thermally-conductive electromagnetic interference (EMI) absorber.

Clause 31: The material of any preceding clause, wherein the material comprises a thermally reversable, silicone free thermally-conductive gap filler pad.

Clause 32: The material of any preceding clause, wherein: the material is a thermal interface material comprising a thermoplastic resin system free of silicone and styrenic block copolymers, and a ceramic filler system comprising thermally conductive particles; the processing oil is dispersed within the thermoplastic resin system; and the thermoplastic resin system includes the polyisobutene-based thickener; whereby the thermal interface material is configured to have a Shore 00 hardness of less than 45 measured at 3 seconds and a thermal conductivity of at least 10 Watts per meter per Kelvin (W/mK) as determined by Hot Disk Thermal Constants Analyzer, while maintaining elastic recoverability after repeated compressive deflection.

Clause 33: The material of clause 32, wherein the thermal interface material: is free of silicone and styrenic block copolymers; remains thermoplastically reversible at temperatures encountered during normal device operation; softens under application heat without undergoing chemical curing or phase change melting so as to reduce interfacial contact resistance after assembly; and achieves a thermal resistance of no greater than 0.60 °C·cm²/W at 30% compressive deflection, measured according to ASTM D5470, under an applied pressure of 30 psi or less.

Clause 34: The material of claim 32, wherein the polyisobutene based thermoplastic thickener is non crosslinked and non-curing during use; the processing oil is miscible with the polyisobutene based thermoplastic thickener; and thermally conductive ceramic filler is dispersed within the thermoplastic resin system; whereby the thermal interface material: is free of silicone and styrenic block copolymers; remains thermoplastically reversible at temperatures encountered during normal device operation; softens under application heat without undergoing chemical curing or phase change melting so as to reduce interfacial contact resistance after assembly; and achieves a thermal resistance of no greater than 0.60 °C·cm²/W at 30% compressive deflection, measured according to ASTM D5470, under an applied pressure of 30 psi or less.

Clause 35: The material of clause 32, wherein: the polyisobutene based thermoplastic thickener comprises a hydrogenated polyisobutene homopolymer having a Shore A hardness of less than 10 at 10 seconds and 25 °C; the thermoplastic resin system contains no crosslinking agents, catalysts, or cure initiators; and the material exhibits less than 15% oil migration after exposure to 125 °C for 1,000 hours.

Clause 36: The material of any preceding clause, wherein: the material is a silicone free thermal interface material comprising the thermoplastic polyisobutene thickener and the processing oil; the silicone free thermal interface material retains dimensional stability and exhibits less than 15% oil migration after exposure to 125 °C for 1,000 hours and has a thermal conductivity of at least 10 Watts per meter per Kelvin (W/mK) as determined by Hot Disk Thermal Constants Analyzer.

Clause 37: A device or system comprising the material of any preceding clause used for managing thermal properties of the device or system.

Clause 38: A method of enhancing performance of a material useful for management of heat and/or electromagnetic interference (EMI), the method comprising using a thermoplastic thickener with processing oil; wherein the thermoplastic thickener has a durometer less than 10 Shore A 10 seconds at room temperature or a temperature of about 25 degrees Celsius; and/or wherein the thermoplastic thickener comprises polyisobutene; and/or wherein the thermoplastic thickener does not include block copolymer such that the thermoplastic thickener enhances performance of the material (as compared to another material having a similar stiffness/secant module of elasticity and a substantially same filler loading but which includes processing oil and diblock styrenic copolymer and/or triblock styrenic copolymer) by one or more of: less oil bleed; less occurrence of hardening over time at elevated temperature; lower secant modulus of elasticity; and/or achievement of a target secant modulus of elasticity while using less processing oil and a lower processing oil to thickening agent ratio in the material.

Clause 39: The method of clause 38, wherein the method selectively includes using a thermoplastic thickener that comprises polyisobutene hydrogenated homopolymer.

Clause 40: The method of clause 38 or 39, wherein the method includes selectively using a thermoplastic thickener that is soft/compliant, stable, and miscible with the processing oil.

Clause 41: The method of any one of clauses 38 to 40, wherein the material is free of styrenic block copolymer and/or does not include detectable styrenic block copolymer.

Clause 42: The method of any one of clauses 38 to 41, wherein the material is free of block copolymer and/or does not include detectable block copolymer.

Clause 43: The method of any one of clauses 38 to 42, wherein the method includes selectively using a thermoplastic thickener that does not include block copolymer such that the thermoplastic thickener enhances performance of the material.

Clause 44: The method of any one of clauses 38 to 43, wherein the thermoplastic thickener does not include block copolymer such that the material is usable with less oil bleed and/or less occurrence of hardening over time at elevated temperature as compared to another material having a similar stiffness/secant module of elasticity and a substantially same filler loading but which includes processing oil and diblock styrenic copolymer and/or triblock styrenic copolymer.

Clause 45: The method of any one of clauses 38 to 44, wherein: the material includes a ratio of styrenic block copolymer to the processing oil less than 0.1; the material includes a non-block copolymer resin system having a lower secant modulus of elasticity than a block copolymer resin system including diblock styrenic copolymer and triblock styrenic copolymer; and the lower secant modulus of elasticity of the non-block copolymer resin system enables the use of less processing oil and a lower processing oil to thickening agent ratio in the material to achieve a target secant modulus of elasticity, whereby the less processing oil and the lower processing oil to thickening agent ratio allows the material including the non-block copolymer resin system to be usable with less oil bleed as compared to a material including the block copolymer resin system and a higher processing oil to thickening agent ratio to achieve the target secant modulus of elasticity.

Clause 46: The method of any one of clauses 38 to 45, wherein the method comprises using the thermoplastic thickener that does not include block copolymer to enhance performance of the material (as compared to another material having a similar stiffness/secant module of elasticity and a substantially same filler loading but which includes processing oil and diblock styrenic copolymer and/or triblock styrenic copolymer) by one or more of: less oil bleed; less occurrence of hardening over time at elevated temperature; lower secant modulus of elasticity; and/or achievement of a target secant modulus of elasticity while using less processing oil and a lower processing oil to thickening agent ratio in the material.

Clause 47: The method of any one of clauses 38 to 46, wherein the material comprises a resin system that includes the processing oil and the thermoplastic polymer.

Clause 48: The method of clause 47, wherein the resin system comprises: a thermoplastic resin system including the processing oil and the thermoplastic polymer; and/or a silicone free resin system including the processing oil and the thermoplastic polymer.

Clause 49: The method of any one of clauses 38 to 48, wherein the method includes adding one or more fillers to the material.

Clause 50: The method of clause 49, wherein the one or more fillers comprise one or more of: thermally-conductive filler(s); electrically-conductive filler(s); electromagnetic wave absorbing filler(s); dielectric filler(s); and filler(s) that has two or more properties of being thermally conductive, electrically conductive, dielectric, and electromagnetic wave absorbing.

Clause 51: The method of clause 44 or 50, wherein the one or more fillers comprise one or more of alumina, zinc oxide, boron nitride, silicon nitride, aluminum, aluminum nitride, diamond, aluminum metal powder, iron, metallic oxides, graphite, silicon carbide, and ceramic.

Clause 52: The method of any one of clauses 38 to 51, wherein the material is a thermal interface material, an EMI absorber material, a thermally-conductive absorber material, an electrically-conductive material, or a combination of two or more thereof.

Clause 53: The method of any one of clauses 38 to 52, wherein the material comprises a thermal gap filler pad, a thermal phase change material, a thermal putty, a thermal grease, and/or a dispensable thermal interface material.

Clause 54: The method of any one of clauses 38 to 53, wherein the material comprises a thermally-conductive electromagnetic interference (EMI) absorber.

Clause 55: The method of any one of clauses 38 to 54, wherein the material comprises a thermally reversable, silicone free thermally-conductive gap filler pad.

Clause 56: The method of any one of clauses 38 to 55, wherein the method includes using the material within a device or system for managing thermal properties of the device or system.

Example embodiments are provided so that this disclosure will be thorough and will fully convey the scope to those who are skilled in the art. Numerous specific details are set forth such as examples of specific components, devices, and methods, to provide a thorough understanding of embodiments of the present disclosure. It will be apparent to those skilled in the art that specific details need not be employed, that example embodiments may be embodied in many different forms, and that neither should be construed to limit the scope of the disclosure. In some example embodiments, well-known processes, well-known device structures, and well-known technologies are not described in detail. In addition, advantages and improvements that may be achieved with one or more exemplary embodiments of the present disclosure are provided for purpose of illustration only and do not limit the scope of the present disclosure, as exemplary embodiments disclosed herein may provide all or none of the above mentioned advantages and improvements and still fall within the scope of the present disclosure.

Specific dimensions, specific materials, and/or specific shapes disclosed herein are example in nature and do not limit the scope of the present disclosure. The disclosure herein of particular values and particular ranges of values for given parameters are not exclusive of other values and ranges of values that may be useful in one or more of the examples disclosed herein. Moreover, it is envisioned that any two particular values for a specific parameter stated herein may define the endpoints of a range of values that may be suitable for the given parameter (*i.e.,* the disclosure of a first value and a second value for a given parameter can be interpreted as disclosing that any value between the first and second values could also be employed for the given parameter). For example, if Parameter X is exemplified herein to have value A and also exemplified to have value Z, it is envisioned that parameter X may have a range of values from about A to about Z. Similarly, it is envisioned that disclosure of two or more ranges of values for a parameter (whether such ranges are nested, overlapping or distinct) subsume all possible combination of ranges for the value that might be claimed using endpoints of the disclosed ranges. For example, if parameter X is exemplified herein to have values in the range of 1 - 10, or 2 - 9, or 3 - 8, it is also envisioned that Parameter X may have other ranges of values including 1 - 9, 1 - 8, 1 - 3, 1 - 2, 2 - 10, 2 - 8, 2 - 3, 3 - 10, and 3 - 9.

The terminology used herein is for the purpose of describing particular example embodiments only and is not intended to be limiting. For example, when permissive phrases, such as "may comprise", "may include", and the like, are used herein, at least one embodiment comprises or includes the feature(s). As used herein, the singular forms "a", "an" and "the" may be intended to include the plural forms as well, unless the context clearly indicates otherwise. The terms "comprises," "comprising," "including," and "having," are inclusive and therefore specify the presence of stated features, integers, steps, operations, elements, and/or components, but do not preclude the presence or addition of one or more other features, integers, steps, operations, elements, components, and/or groups thereof. The method steps, processes, and operations described herein are not to be construed as necessarily requiring their performance of the particular order discussed or illustrated, unless specifically identified as an order of performance. It is also to be understood that additional or alternative steps may be employed.

When an element or layer is referred to as being "on", "engaged to", "connected to" or "coupled to" another element or layer, it may be directly on, engaged, connected or coupled to the other element or layer, or intervening elements or layers may be present. In contrast, when an element is referred to as being "directly on," "directly engaged to", "directly connected to" or "directly coupled to" another element or layer, there may be no intervening elements or layers present. Other words used to describe the relationship between elements should be interpreted in a like fashion (*e.g*., "between" versus "directly between," "adjacent" versus "directly adjacent," *etc*.). As used herein, the term "and/or" includes any and all combinations of one or more of the associated listed items.

The term "about" when applied to values indicates that the calculation or the measurement allows some slight imprecision in the value (with some approach to exactness in the value; approximately or reasonably close to the value; nearly). If, for some reason, the imprecision provided by "about" is not otherwise understood in the art with this ordinary meaning, then "about" as used herein indicates at least variations that may arise from ordinary methods of measuring or using such parameters. For example, the terms "generally", "about", and "substantially" may be used herein to mean within manufacturing tolerances. Or for example, the term "about" as used herein when modifying a quantity of an ingredient or reactant of the invention or employed refers to variation in the numerical quantity that can happen through typical measuring and handling procedures used, for example, when making concentrates or solutions in the real world through inadvertent error in these procedures; through differences in the manufacture, source, or purity of the ingredients employed to make the compositions or carry out the methods; and the like. The term "about" also encompasses amounts that differ due to different equilibrium conditions for a composition resulting from a particular initial mixture. Whether or not modified by the term "about", equivalents to the quantities are included.

Although the terms first, second, third, *etc.* may be used herein to describe various elements, components, regions, layers and/or sections, these elements, components, regions, layers and/or sections should not be limited by these terms. These terms may be only used to distinguish one element, component, region, layer or section from another region, layer or section. Terms such as "first," "second," and other numerical terms when used herein do not imply a sequence or order unless clearly indicated by the context. Thus, a first element, component, region, layer or section discussed below could be termed a second element, component, region, layer or section without departing from the teachings of the example embodiments.

Spatially relative terms, such as "inner," "outer," "beneath", "below", "lower", "above", "upper" and the like, may be used herein for ease of description to describe one element or feature's relationship to another element(s) or feature(s) as illustrated in the figures. Spatially relative terms may be intended to encompass different orientations of the device in use or operation in addition to the orientation depicted in the figures. For example, if the device in the figures is turned over, elements described as "below" or "beneath" other elements or features would then be oriented "above" the other elements or features. Thus, the example term "below" can encompass both an orientation of above and below. The device may be otherwise oriented (rotated 90 degrees or at other orientations) and the spatially relative descriptors used herein interpreted accordingly.

The foregoing description of the embodiments has been provided for purposes of illustration and description. It is not intended to be exhaustive or to limit the disclosure. Individual elements, intended or stated uses, or features of a particular embodiment are generally not limited to that particular embodiment, but, where applicable, are interchangeable and can be used in a selected embodiment, even if not specifically shown or described. The same may also be varied in many ways. Such variations are not to be regarded as a departure from the disclosure, and all such modifications are intended to be included within the scope of the disclosure.

## Claims

1. A material useful for the management of heat and/or electromagnetic interference (EMI), the material comprising processing oil and a thermoplastic thickener including polyisobutene and/or having a durometer less than 10 Shore A 10 seconds at room temperature or a temperature of about 25 degrees Celsius.

2. The material of claim 1, wherein:
the material is a thermal interface material comprising a thermoplastic resin system free of silicone and styrenic block copolymers, and a ceramic filler system comprising thermally conductive particles;
the processing oil is dispersed within the thermoplastic resin system; and
the thermoplastic resin system includes the polyisobutene-based thickener;
whereby the thermal interface material is configured to have a Shore 00 hardness of less than 45 measured at 3 seconds and a thermal conductivity of at least 10 Watts per meter per Kelvin (W/mK) as determined by Hot Disk Thermal Constants Analyzer, while maintaining elastic recoverability after repeated compressive deflection.

3. The material of claim 2, wherein the thermal interface material:
is free of silicone and styrenic block copolymers;
remains thermoplastically reversible at temperatures encountered during normal device operation;
softens under application heat without undergoing chemical curing or phase-change melting so as to reduce interfacial contact resistance after assembly; and
achieves a thermal resistance of no greater than 0.60 °C·cm²/W at 30% compressive deflection, measured according to ASTM D5470, under an applied pressure of 30 psi or less.

4. The material of claim 2, wherein:
the polyisobutene-based thermoplastic thickener is non-crosslinked and non-curing during use;
the processing oil is miscible with the polyisobutene-based thermoplastic thickener; and
thermally conductive ceramic filler is dispersed within the thermoplastic resin system;
whereby the thermal interface material:
is free of silicone and styrenic block copolymers;
remains thermoplastically reversible at temperatures encountered during normal device operation;
softens under application heat without undergoing chemical curing or phase-change melting so as to reduce interfacial contact resistance after assembly; and
achieves a thermal resistance of no greater than 0.60 °C·cm²/W at 30% compressive deflection, measured according to ASTM D5470, under an applied pressure of 30 psi or less.

5. The material of claim 2, wherein:
the polyisobutene-based thermoplastic thickener comprises a hydrogenated polyisobutene homopolymer having a Shore A hardness of less than 10 at 10 seconds and 25 °C;
the thermoplastic resin system contains no crosslinking agents, catalysts, or cure initiators; and
the material exhibits less than 15% oil migration after exposure to 125 °C for 1,000 hours.

6. The material of claim 1, wherein:
the material is a silicone-free thermal interface material comprising the thermoplastic polyisobutene thickener and the processing oil;
the silicone-free thermal interface material retains dimensional stability and exhibits less than 15% oil migration after exposure to 125 °C for 1,000 hours and has a thermal conductivity of at least 10 Watts per meter per Kelvin (W/mK) as determined by Hot Disk Thermal Constants Analyzer.

7. The material of claim 1, wherein the thermoplastic thickener comprises polyisobutene hydrogenated homopolymer.

8. The material of claim 1, wherein the material is free of block copolymer and/or does not include detectable block copolymer.

9. The material of claim 1, wherein the thermoplastic thickener does not include block copolymer such that the thermoplastic thickener enhances performance of the material, whereby the material is usable with less oil bleed and/or less occurrence of hardening over time at elevated temperature as compared to another material having a similar stiffness/secant module of elasticity and a substantially same filler loading but which includes processing oil and diblock styrenic copolymer and/or triblock styrenic copolymer.

10. The material of claim 1, wherein:
the material includes a non-block copolymer resin system having a lower secant modulus of elasticity than a block copolymer resin system including diblock styrenic copolymer and triblock styrenic copolymer; and
the lower secant modulus of elasticity of the non-block copolymer resin system enables the use of less processing oil and a lower processing oil to thickening agent ratio in the material to achieve a target secant modulus of elasticity, whereby the less processing oil and the lower processing oil to thickening agent ratio allows the material including the non-block copolymer resin system to be usable with less oil bleed as compared to a material including the block copolymer resin system and a higher processing oil to thickening agent ratio to achieve the target secant modulus of elasticity.

11. The material of claim 1, wherein the material includes a ratio of styrenic block copolymer to the processing oil less than 0.1.

12. The material of any one of claims 1 to 10, wherein the thermoplastic thickener does not include block copolymer such that the thermoplastic thickener enhances performance of the material (as compared to another material having a similar stiffness/secant module of elasticity and a substantially same filler loading but which includes processing oil and diblock styrenic copolymer and/or triblock styrenic copolymer) by one or more of:
less oil bleed;
less occurrence of hardening over time at elevated temperature;
lower secant modulus of elasticity; and/or
achievement of a target secant modulus of elasticity while using less processing oil and a lower processing oil to thickening agent ratio in the material.

13. The material of claim 12, wherein the thermoplastic thickener comprises polyisobutene hydrogenated homopolymer having a durometer less than 10 Shore A 10 seconds at room temperature or a temperature of about 25 degrees Celsius.

14. A method of enhancing performance of a material useful for management of heat and/or electromagnetic interference (EMI), the method comprising using a thermoplastic thickener with processing oil, wherein the thermoplastic thickener comprises polyisobutene and/or has a durometer less than 10 Shore A 10 seconds at room temperature or a temperature of about 25 degrees Celsius.

15. The method of claim 14, wherein:
the method includes selectively using a thermoplastic thickener that comprises polyisobutene hydrogenated homopolymer;
the material is a thermal interface material comprising a thermoplastic resin system free of silicone and styrenic block copolymers, and a ceramic filler system comprising thermally conductive particles;
the processing oil is dispersed within the thermoplastic resin system;
the thermoplastic resin system includes the polyisobutene-based thickener; and
the thermal interface material is configured to have a Shore 00 hardness of less than 45 measured at 3 seconds and a thermal conductivity of at least 10 Watts per meter per Kelvin (W/mK) as determined by Hot Disk Thermal Constants Analyzer, while maintaining elastic recoverability after repeated compressive deflection.
